Europäisches Patentamt

European Patent Office

Office européen des brevets

(19)

(11) Publication number: **0 254 065**

**A2**

(12) **EUROPEAN PATENT APPLICATION**

(21) Application number: **87109120.3**

(22) Date of filing: **25.06.87**

(51) Int. Cl.⁴: **G11C 7/00**

(30) Priority: **25.06.86 JP 150353/86**

(43) Date of publication of application:
**27.01.88 Bulletin 88/04**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Watanabe, Hiroshi**
**NEC Corporation 33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) **Address multiplex type semi-conductor memory.**

(57) A memory device of address multiplex type which can outputs read data in sequence at a high speed is disclosed. The memory device is featured by an output circuit which maintains a read output generated under both active states of a row address strobe signal and a column address strobe signal, when one of the row and column address strobe signals is still active thereby to enlarge an effective width of the read output.

Fig. 4

EP 0 254 065 A2

## ADDRESS MULTIPLEX TYPE SEMICONDUCTOR MEMORY

BACKGROUND OF THE INVENTION

The present invention relates to a dynamic type semiconductor memory device, and more particularly to the employing address multiplexing - scheme.

Address multiplexing scheme has been widely utilized in large scale of memory devices in order to reduce number in address input terminals. Such memory employing - the address multiplexing - scheme is structured such that row address signals are taken into the memory and held in response to an active level of a row address strobe signal ( $\overline{RAS}$ ) through a set of address input terminals and column address signals are taken into the memory via the same set of address input terminals in response to an active level of a column strobe signal ( $\overline{CAS}$ ). Thus, the same set of address input terminals are used twice to incorporate both of row address signals and column address signals, and therefore the number of address input terminal can be greatly reduced. In this memory, many timing signals for controlling the respective peripheral circuits and a memory cell array are generated by $\overline{RAS}$ and $\overline{CAS}$ in a predetermined manner.

Namely, when $\overline{RAS}$ is changed to an active (low) level, row series timing signals for enabling a row address buffer, a row decoder and sense amplifiers in a memory cell array in sequence.

Then, under the active state of $\overline{RAS}$, when $\overline{CAS}$ is changed to an active (low) level, column series timing signals for enabling a column address buffer, a column address decoder and an output circuit are sequentially generated. Those column series timing signals are reset when $\overline{CAS}$ is changed to an inactive (high) level during the active period of $\overline{RAS}$. Thus, column series circuits such as the column address buffer, column decoder and the output circuit are controlled substantially by $\overline{CAS}$. This feature is utilized in a PAGE mode or a NIBBLE mode operation. PAGE or NIBBLE mode operation is achieved such that memory cells belonging to a row selected by row address signals incorporated by the active level of $\overline{RAS}$ are selected in sequence by repeating $\overline{CAS}$ between its active and inactive levels. This PAGE or NIBBLE mode is advantageous in reading a plurality of data stored in the same selected row at a high speed. In the conventional memory device, when $\overline{CAS}$ is returned to the inactive level from the active level during the active period of $\overline{RAS}$, the output circuit controlled to make an output terminal in a high impedance (floating) state immediately. Then, when $\overline{CAS}$ is changed to the active again, a read data is generated to the output terminal through a predetermined delay time necessitated by the operations of the column series circuits. Thus, an effective period of data output is far shorter than each cycle time of $\overline{CAS}$ at least by the above predetermined delay time. Thus, if each cycle time of $\overline{CAS}$ is made shorter to increase access speed, it would be difficult to obtain an enough output width or period.

SUMMARY OF THE INVENTION;

It is an object of the present invention is to provide a dynamic memory device which enlarges the effective width of data output even in PAGE or NIBBLE mode .

The dynamic type memory device according to the present invention is of the address multiplexing type and featured by a data output which latches read-out data from a selected memory cell and outputs the read-out data when both of a row address strobe signal and a column address strobe signal are changed to their active levels from their inactive level, and maintains the read-out data when at least one of the row address strobe signal and the column address signal remains at its active level and is reset when both of the row address strobe signal and the column address strobe signals are changed to their inactive levels from their active levels.

According to the present invention, in the PAGE or NIBBLE mode in which the column strobe signal is repeatedly changed between its active level and inactive level under the active level of the row address strobe, the output circuit is not reset but it holds the read-out data already latched therein even when the column strobe signal is changed to its inactive level. Therefore, the read-out data latched at the active period of the column address strobe signal is maintained or held in the subsequent inactive period of the column address strobe signal as far as the row address strobe signal is maintained active.

Therefore, the effective data width of the read-out data generated by the output circuit can be greatly enlarged.

BRIEF DESCRIPTION OF THE DRAWINGS;

Fig. 1 is a schematic block diagram of a memory device according to a prior art;

Fig. 2 is a timing diagram of a random access cycle of the memory of Fig. 1;

Fig. 3 is a timing diagram of a PAGE mode of the memory of Fig. 1;

Fig. 4 is schematic circuit diagram of the output circuit according to one embodiment of the present invention; and

Fig. 5 is a timing diagram of the output circuit of Fig. 4:

DETAILED DESCRIPTION OF THE INVENTION:

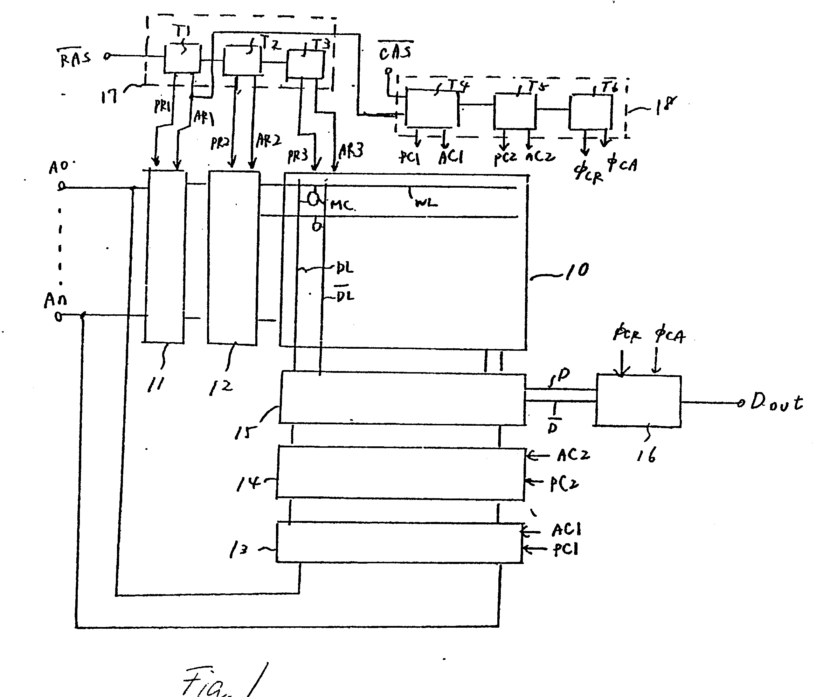

Referring to Fig. 1, a conventional address multiplex type memory device is explained.

The memory device includes a memory array 10, a row address buffer 11, a row address decoder 12, a column address buffer 13, a column address decoder 14, a column selection circuit, an output circuit 16, a row series timing generator 17 and a column series timing generator 18. The memory array 10 includes a plurality of word lines WL arranged in rows, a plurality pairs of digit lines such as DL, $\overline{DL}$ arranged in columns and a plurality of memory cells MC. The timing generator 17 includes delay circuits T1 to T3 and generates enable signals AR1, AR2 and AR3 sequentially when a row address strobe signal $\overline{RAS}$ is changed to its active (low) level and generates reset signals PR1, PR2 and PR3 in a predetermined order in response to change of $\overline{RAS}$ to its inactive (high) level. The timing generator 18 includes delay circuits T4 to T6 and generates enable signals AC1, AC2, $\varnothing_{CA}$ in sequence in response to change of a column address strobe signal ( $\overline{CAS}$ ) to its active (low) level under the active level of $\overline{RAS}$ , and generates reset signals PC1, PC2 and $\varnothing_{CR}$ when at least one of $\overline{RAS}$ and $\overline{CAS}$ changes to its inactive level. In this example, the enable signal AR1 is applied to the timing generator 18, but another enable signal such as AR3 from the generator 17 may be utilized similarly.

The row address buffer 11 latches row address signals applied to a set of address input terminals $A_c$ to $A_n$ in response to the enable signal AR1 generated in response to the active level of $\overline{RAS}$ and then the row decoder 12 selects one of the word lines in accordance with the latched row address signals in response to the enable signal AR3. Thereafter, sense amplifiers (not shown) in the array are energized in response to the enable signal AR3.

While the column address buffer 13 latches column address signals applied at the same set of address terminals $A_0$ to $A_n$ in response to the enable signal AC1 generated when $\overline{CAS}$ changes to the active level with the active level of $\overline{RAS}$ . Then the column address decoder 14 controls the column selection circuit 15 so that one pair of digit lines are electrically connected to a pair of bus lines D and $\overline{D}$ coupled to the output circuit 16 in response to the enable signal AC2, and then the output circuit 16 amplifies a signal difference on the bus lines D and $\overline{D}$ and outputs data at a data output terminal $D_{OUT}$ in response to the enable signal $\varnothing_{CA}$.

When at least one of $\overline{RAS}$ and $\overline{CAS}$ is reset to its inactive (low) level, the column address buffer 13, the column decoder 14 and the output circuit 16 are reset in response to the reset signals PC1, PC2 and $\varnothing_{CR}$, respectively. When $\overline{RAS}$ is reset to its inactive level, the reset signals PR1, PR2 and PR3 are generated and therefore the row address buffer 11, the row address decoder 12 and the memory array 10 are reset or precharged.

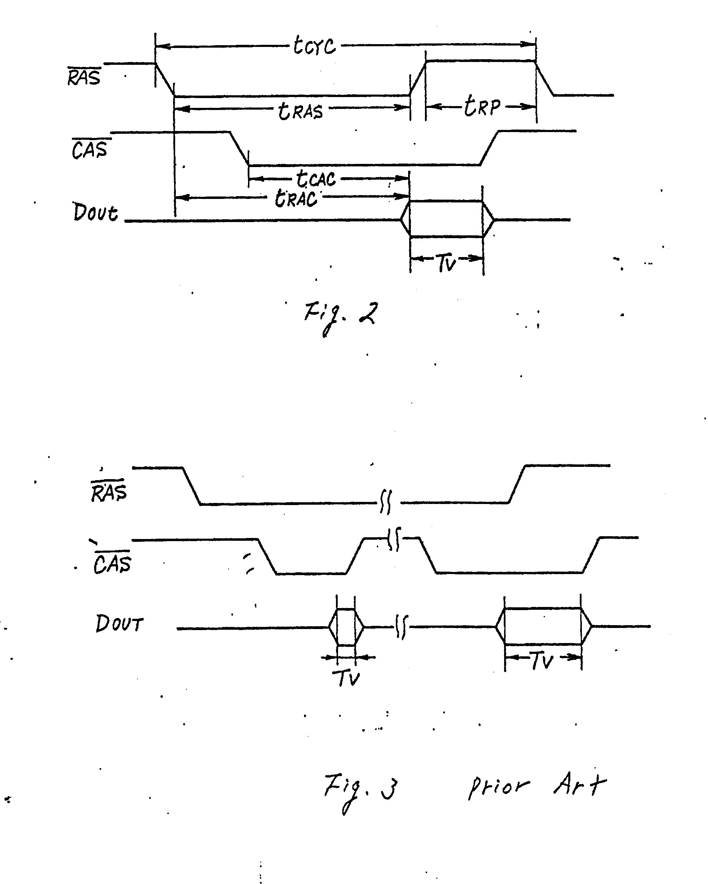

Referring to Fig. 2, a random access cycle of the memory of Fig. 1 is explained.

First, $\overline{RAS}$ is changed to a low active level and row address data is taken in, and thereafter $\overline{CAS}$ is changed to the low active level, column address data is taken. Then a read data $D_{OUT}$ is produced after a row access time t $_{RAC}$ from the change of $\overline{RAS}$ to the active level and after a column access time $t_{CAC}$ from the change of $\overline{CAS}$ to the active level. A minimum value of the active width $t_{RAS}$ of $\overline{RAS}$ is equal to a maximum value of the row access time $t_{RAC}$. Therefore, if the time in which the output $D_{OUT}$ is produced is controlled by $\overline{CAS}$ only, the effective width $T_v$ of $D_{OUT}$ is determined substantially by $\overline{CAS}$ only. Accordingly, if a minimum active width t $_{RAS}$ of $\overline{RAS}$ is given, a precharge period $t_{RP}$ is then initiated and a minimum cycle time $t_{CYC}$ is achieved before the subsequent cycle is initiated. Thus, controlling the output $D_{OUT}$ by $\overline{CAS}$ is effective in carrying out a random access.

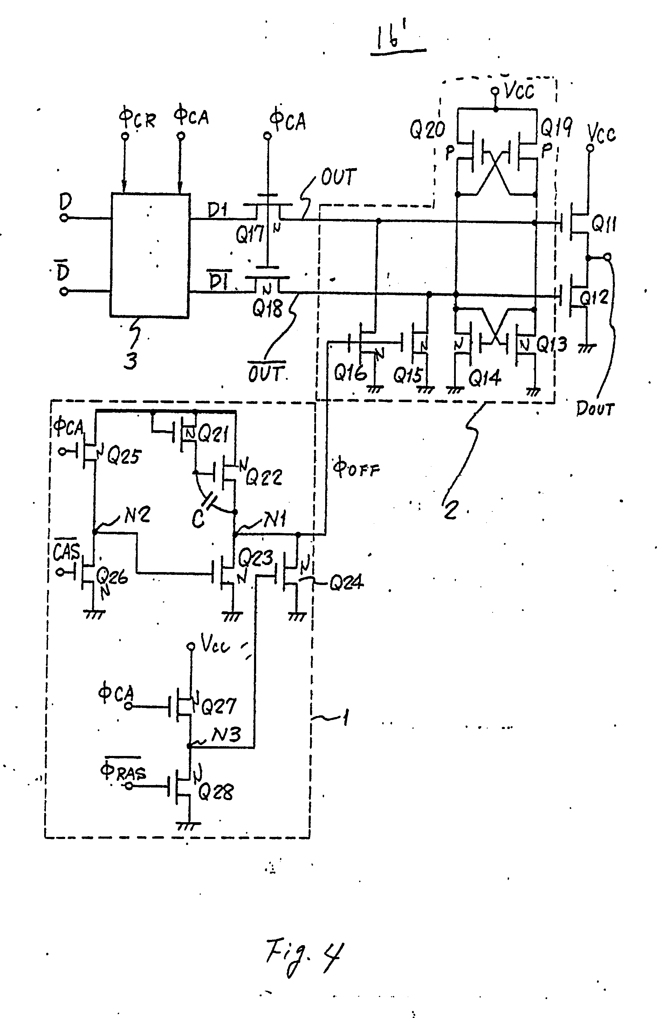

Another access method called PAGE mode or NIBBLE mode is illustrated in Fig. 3.

According to this method, $\overline{RAS}$ is first changed to the active level, and then $\overline{CAS}$ is repeatedly activated to the active level in successive manner so that the memory cells of a selected row in response to the active level of $\overline{RAS}$ are successively selected for read each time when $\overline{CAS}$ is activated. This mode makes it possible to obtain a data rate of high speed as compared with an ordinary random access.

On the other hand, the access time $t_{CAC}$ from $\overline{CAS}$ is usually equal to a minimum value $t_{CAS}$ of the active width of $\overline{CAS}$. Moreover, the output is controlled by $\overline{CAS}$ only and, hence, the output $D_{OUT}$ assumes a high-impedance condition if $\overline{CAS}$ is inactivated immediately after the access time. Therefore, the effective time $T_V$ of data is too short. To maintain the effective time $T_V$ of data, therefore, the active width of $\overline{CAS}$ must be comprised of an access time and a required effective time $T_V$ of data, making it difficult to sufficiently draw the performance of the memory. In the NIBBLE mode. in particular, the cycle time may be as fast as 40 ns. However, if the effective data time $T_V$ is selected to be 20 ns, the effective cycle time becomes 60 ns, which is an increase of 1.5 times.

Thus, it has been difficult to achieve an enough width $T_V$ in the high speed serial access mode such as PAGE mode or NIBBLE mode.

Referring to Fig. 1, an embodiment of the present invention is explained.

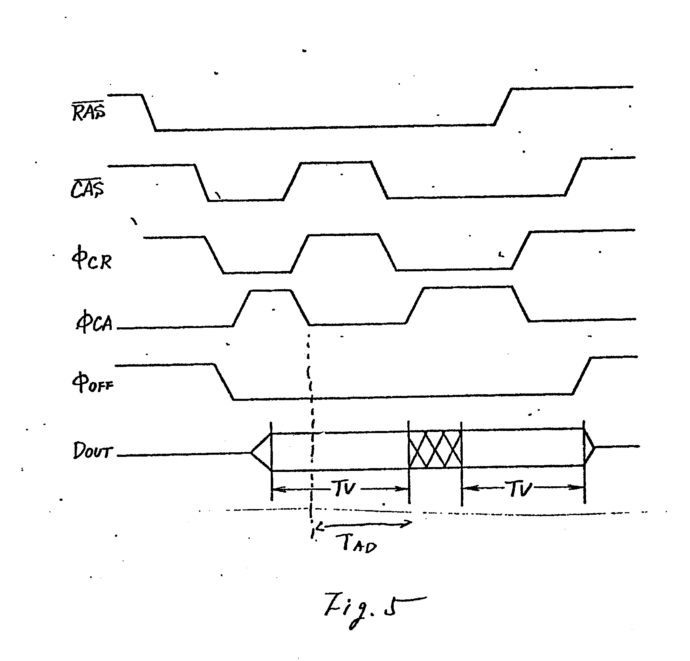

The memory device according to the present embodiment is obtained by replacing the output circuit 16 of the memory of Fig. 1 with the output circuit 16′ of Fig. 4. Therefore, in the following, explanation is given to the output circuit 16′.

The output circuit 16′ includes a pre-driver circuit 3 which is enabled by $\varnothing_{CA}$ and reset by $\varnothing_{CR}$, a latch circuit 2 for holding data at a pair of signal lines OUT and $\overline{OUT}$, a pair of N-channel transfer gate transistors $Q_{17}$ and $Q_{18}$ coupled between OUT, $\overline{OUT}$ and outputs D1 and $\overline{D1}$ of the circuit 3, a push-pull output circuit composed of N-channel transistors $Q_{11}$ and $Q_{12}$, and a latch control circuit 1.

The latch control circuit 1 is composed of N-channel transistors $Q_{21}$ to $Q_{28}$ and have the signals $\varnothing_{CA}$, $\overline{CAS}$, and $\overline{\varnothing}_{RAS}$. The $\overline{\varnothing}_{RAS}$ is the signal of the same phase as $\overline{RAS}$ and may be $\overline{RAS}$ itself or PR1 in Fig. 1. The control circuit 1 generates an output-off signal $\varnothing_{OFF}$ of level "1" when $\overline{RAS}$ and $\overline{CAS}$ are both at their inactive (high, "1") levels, and generates $\varnothing_{OFF}$ of level "0" when both of $\overline{RAS}$ and $\overline{CAS}$ are active (low level) and when one of $\overline{RAS}$ and $\overline{CAS}$ is maintained active after the active states of both $\overline{RAS}$ and $\overline{CAS}$.

The output terminal $D_{OUT}$ is connected to the transistors $Q_{11}$ and $Q_{12}$, and the signal lines OUT and $\overline{OUT}$ are connected to the gates of the transistors $Q_{11}$ and $Q_{12}$. When the signal lines OUT and $\overline{OUT}$ are both of the level "0", the transistors $Q_{11}$ and $Q_{12}$ are rendered nonconductive, and therefore the output terminal $D_{OUT}$ assumes a high-impedance condition. When either one of the output lines OUT and $\overline{OUT}$ assumes the level "1", either one of the transistors $Q_{11}$ and $Q_{12}$ is rendered conductive correspondingly to produce the output "1" or "0" at $D_{OUT}$. The circuit 3 is inactivated or reset by the signal $\varnothing_{CR}$, activated by an activating signal $\varnothing_{CA}$, and produces outputs $D_1$ and $\overline{D_1}$ in response to data at the bus lines D and $\overline{D}$ from the memory cell. When the signal $\varnothing_{CA}$ has the level "1", the outputs $D_1$, $\overline{D_1}$ are transmitted to the signal lines OUT and $\overline{OUT}$ through the transistors $Q_{17}$ and $Q_{18}$, so that either one of the output transistors $Q_{11}$ and $Q_{12}$ is rendered conductive with the other nonconductive. N-channel transistors $Q_{13}$ and $Q_{14}$ constitute a flip-flop for latching the signals of signal lines OUT and $\overline{OUT}$, and work to stabilize the level "0" at the output $D_{OUT}$. There may further be provided a flip-flop consisting of P-channel transistors $Q_{19}$ and $Q_{20}$ to stabilize the level "1". N-channel transistors $Q_{15}$ and $Q_{16}$ work as switches so that the signal lines OUT and $\overline{OUT}$ both are clamped to the level "0" whtn the output-off signal $\varnothing_{OFF}$ is of "1" level.

Fig. 5 is a diagram of signal waveforms for explaining the operation of the embodiment.

The signals $\overline{RAS}$ and $\overline{CAS}$ are under the activated condition when they have the level "0" according to the customary manner. When the signal $\overline{RAS}$ is activated and then the signal $\overline{CAS}$ is activated, the signal $\varnothing_{CR}$ changes from "1" to "0" and the signal $\varnothing_{OFF}$ changes from "1" to "0". Then, the signal $\varnothing_{CA}$ changes from "0" to "1", and the outputs $D_1$ and $\overline{D_1}$ of the circuit 3 are transmitted to the signal lines OUT and to determine the output signal $D_{OUT}$. Then, as the signal $\overline{CAS}$ is inactivated, the signal $\varnothing_{CA}$ changes from "1" to "0", the signal $\varnothing_{CR}$ changes from "0" to "1", and whereby the circuit 3 is disenabled or reset so that precharge of the next data cycle is initiated. However, since the output-off signal $\varnothing_{OFF}$ is still of the level "0", the transistors $Q_{17}$ and $Q_{18}$ are still nonconductive although the signal $\varnothing_{CA}$ assumes the level "0". Therefore, the signal lines OUT and $\overline{OUT}$ maintain the same data condition as that of when they have been activated by "1" level of $\varnothing_{CA}$ and the same output data is kept at the terminal $D_{OUT}$. That is, the effective time $T_V$ of output is extended by a period $T_{AD}$. As the signal $\overline{CAS}$ is activated again, the signal $\varnothing_{CR}$ assumes the level "0", the signal $\varnothing_{CA}$ assumes the level "1", and the data of the previous cycle is destroyed as the signal lines OUT and $\overline{OUT}$ are connected to the output terminals $D_1$ and $\overline{D_1}$ of the circuit 3. Since the signal $\varnothing_{CA}$ assumes the level "1", the data appears after a predetermined access time has passed. Thereafter, as the signal $\overline{RAS}$ is inactivated, the enable signals all change into the inactivated state. Therefore, the signal $\varnothing_{CA}$ changes into the level "0" and the reset signal $\varnothing_{CR}$ changes into the level "1" separately from the control of the signal $\overline{CAS}$ However, since the output-off signal $\phi_{OFF}$ maintains the level "0", the output continues to maintain the same data at $D_{OUT}$. Furthermore, as the signal $\overline{CAS}$ becomes inactivated and the output-off signal $\phi_{OFF}$ assumes the level "1" to make transistors $Q_{15}$ and $Q_{16}$ conductive so that the signal lines OUT and $\overline{OUT}$ both assumes the level "0", the output $D_{OUT}$ assumes a high-impedance condition.

The control circuit 1 will now be described in more detail. First, in an ordinary address multiplex type semiconductor memory, the internal enable signals generated from $\overline{CAS}$ are all inactivated when the $\overline{RAS}$ is inactivated irrespective of whether the $\overline{CAS}$ is activated or inactivated. This is to decrease the consumption of electric power since there is no need of carrying out the input or output operation when there is no access to the memory cell. Therefore, as the signal $\overline{RAS}$ is inactivated, the signal $\phi_{CA}$ assumes the level "0", and the signal $\overline{\phi}_{RAS}$ assumes the level "1". Accordingly, when the transistors $Q_{25}$ and $Q_{27}$ are rendered nonconductive and the signal $\overline{CAS}$ assumes the condition "1" (i.e., inactivated condition), the transistor $Q_{26}$ is rendered conductive and the transistor $Q_{28}$ is rendered conductive, so that nodes N2 and N3 assume the level "0". Since transistors $Q_{23}$ and $Q_{24}$ are rendered nonconductive, a node N1, i.e., the output-off signal $\phi_{OFF}$ assumes the level "1" due to the load circuit consisting of transistors $Q_{21}$, $Q_{22}$ and a boot capacity C. The signal $\phi_{CA}$ maintains the level "0" even when the signal $\overline{CAS}$ of the level "0" is input from the external unit. The node N2 therefore is not allowed to assume the level "1", and the output-off signal $\phi_{OFF}$ maintains the level "1" so that the output terminal $D_{OUT}$ is maintained under a high-impedance condition.

As the signals $\overline{RAS}$ and $\overline{CAS}$ are both activated, on the other hand, the $\overline{CAS}$ from the external unit assumes the level "0" as a matter of course, the signal $\overline{\phi}_{RAS}$ assumes the level "0", the signal $\phi_{CA}$ assumes the level "1", the nodes N2 and N3 both assumes the level "1", and the output-off signal $\phi_{OFF}$ assumes the level "0". As the signal $\overline{CAS}$ becomes inactive again, the node N2 assumes the level "0". However, since the signal $\overline{RAS}$ is being activated, the node N3 maintains the level "1" and the output-off signal $\phi_{OFF}$ maintains the level "0". On the other hand, if the output is once produced and the input $\overline{CAS}$ from the external unit maintains the level "0", the node N2 maintains the level "1" no matter when the signal $\overline{RAS}$ is inactivated and the node N3 assumes the level "0". The output-off signal maintains the level "0" until the signal $\overline{CAS}$ of the level "1" is input from the external unit, and the output-off signal $\phi_{OFF}$ of a predetermined waveform is obtained as shown in Fig. 2.

According to the present invention as described above, the output-off signal $\phi_{OFF}$ of the level "1" is produced when the signals $\overline{RAS}$ and $\overline{CAS}$ are both under the inactivated condition, and the latch circuit 2 is disenabled. When both of the signals $\overline{RAS}$ and $\overline{CAS}$ are under the activated condition, the output-off signal $\phi_{OFF}$ of the level "0" is produced to enable the latch circuit 2 and the output data is latched therein. The output data continues to be latched even when both of these signals assume different conditions, because the output-off signal $\phi_{OFF}$ is in the "0" level at that time. Therefore, effective time of output can be extended, and high-speed operation can be carried out, while maintaining compatibility with the existing random access memory.

**Claims**

1. A memory device comprising a memory array of memory cells arranged in rows and columns, means for receiving a row address strobe signal, means for receiving a column address strobe signal, a set of address input terminals, a row address buffer for operatively holding signals at said address input terminals as row address signals in response to an active level of said row address strobe signal, a column address buffer for operatively holding signals at said address input terminals as column address signals, row selection means for selecting one of rows of said memory array in accordance with said row address signals, data extracting means for extracting a data from one of memory cells in the selected row in accordance with said column address signals, and an output circuit receiving the extracted data and operatively generating an output data, said output circuit being enabled to generate said output data in a first mode in which both of said row address strobe signal and said column strobe signal are active in levels and in a second mode in which one of said row strobe signal and column strobe signal is still active subsequent to said first mode and said output circuit being disenabled in a third mode in which both of said row address strobe signal and said column address strobe signals are inactive in levels.

2. The memory device according to claim 1, in which said output circuit includes an output terminal, a push-pull type output circuit having an output coupled to said output terminal and composed of first and second transistors, a pair of signal lines coupled to the gates of said first and second transistors, a latch circuit coupled to said first and second signal lines for holding data on said first and second signal lines, a transfer circuit for operatively applying said extracted data to said first and second signal lines, a clamp circuit for operatively clamping said first and second signal lines to a reference voltage by rendering both of said first and second transistors conductive to disenable said output circuit, and a control circuit for enabling said clamp circuit when both of said row address strobe signal and said column address signal are inactive in levels.

3. An output circuit for a memory device having a memory array of memory cells arranged in rows and columns in which selection of the rows of said memory array is performed in response to an active state of a row address strobe signal and a data is extracted from one of memory cells in the selected row in response to an active state of a column address strobe signal under the active state of said row address strobe signal, comprising a data output terminal, a push-pull circuit having a pair of input terminals and an output terminal coupled to said data output terminal, a pair of signal lines coupled to said pair of input terminals of said push-pull circuit, means for operatively applying true and complementary signals of the extracted data to said pair of signal lines, a latch circuit coupled to said pair of signal lines and holding signals at said pair of signal lines, and a clamp circuit coupled to said pair of signal lines for clamping said pair of signal lines to a reference potential thereby to disenable said push-pull circuit only when both of said row address strobe signal and said column strobe signal are rendered their inactive states.

4. The output circuit according to claim 3, in which said push-pull circuit includes first and second transistors connected in series between a pair of power voltage terminals and having gates coupled to said pair of signal lines.

5. The output circuit according to claim 3, in which said applying means includes a pre-drive circuit having a pair of input terminals receiving said true and complementary signals and a pair of output terminals and a pair of transfer gates coupled between said pair of signal lines and said pair of output terminals of said pre-drive circuit, said pair of transfer gates being enabled when both of said row address strobe signal and said column strobe signal are active.

6. The output circuit according to claim 3, in which said clamp circuit includes a pair of clamp transistors coupled between said pair of signal lines and said reference potential and control means for making said pair of clamp transistors conductive only when both of said row address strobe signal and said column address strobe signal are inactive.

Fig. 1

Prior Art

0 254 065

0 254 065

Fig. 2

Fig. 3    Prior Art

0 254 065

16'

Fig. 4

Fig. 5